# EUROPEAN PATENT APPLICATION

(11) **EP 3 886 142 A2**
(43) Date of publication of application: **29.09.2021**
(21) Application number: 21159519.4
(22) Date of filing: 26.02.2021
(51) Int. Cl.: H01J 61/16, F21V 7/00, F21V 23/04, H01J 61/35, H01J 65/04

(54) **EXCIMER LAMP AND LIGHT IRRADIATION DEVICE INCLUDING THE SAME**

(30) Priority: 26.03.2020 JP 2020055316
(71) Applicant: Ushio Denki Kabushiki Kaisha, Tokyo-to 100-8150 (JP)
(72) Inventor: HORIBE, Hiroki, Chiyoda-ku, Tokyo 100-8150 (JP); FUJITA, Naoki, Chiyoda-ku, Tokyo 100-8150 (JP)
(74) Representative: Tomerius, Isabel

(57) **Abstract**

An excimer lamp (2) includes a long light-emitting tube (10) transparent to ultraviolet light, a pair of electrodes (11) disposed separately along the radial direction of the light-emitting tube (10), and a reflective coating (14) formed on the inner wall surface (10b) of the light-emitting tube (10). The reflective coating (14) includes a first reflective area (14p) facing a light-emitting surface (12) that emits light toward a light irradiation target area, and a second reflective area (14q) facing a light-collecting area (13) disposed at a position different from the light-emitting surface (12).

## Description

### TECHNICAL FIELD

The present invention relates to an excimer lamp and a light irradiation device including the excimer lamp.

### BACKGROUND ART

Ultraviolet light has been used for manufacturing semiconductor devices and liquid crystal panels or generating ozone for air cleaning. Excimer lamps, such as those described in the following Patent Literature 1, have been used as a light source that emits ultraviolet light. The Patent Literature 1 discloses an excimer lamp with a reflective coating formed on the inner wall of the light-emitting tube to efficiently irradiate an irradiated object with ultraviolet light emitted from the light-emitting tube.

In the manufacturing of semiconductors and liquid crystal panels, it is desirable to have uniform illuminance on each irradiated object (workpiece) in order to reduce the quality variation among its products. In this view, Patent Literature 2 discloses a configuration of detecting the amount of light, in which a light-collecting opening is provided on a part of the inner wall surface that is different from the light-emitting surface, in order to ensure the stable irradiation from the light irradiation device toward an irradiated object.

### CITATION LIST

### PATENT LITERATURE

Patent Literature 1: Japanese Patent Application Laid-Open Publication No. 2007 - 335350
Patent Literature 2: Japanese Patent Application Laid-Open Publication No. 2010 - 225343

### SUMMARY OF THE INVENTION

### Technical Problem

The present inventor examined the configuration of the excimer lamp disclosed in the Patent Literature 2, and found the following issue. Hereinafter, the issue is explained with reference to drawings.

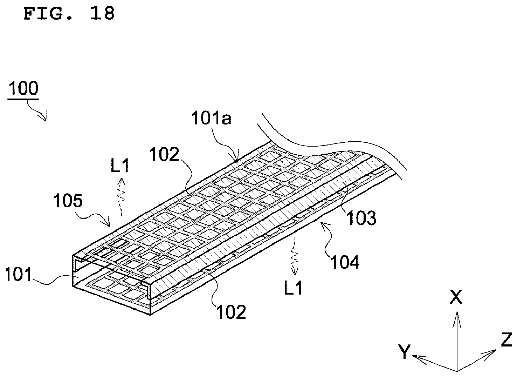

FIG. 18 is an enlarged perspective view near a light-collecting area 105 of an excimer lamp 100 of the conventional configuration. The excimer lamp 100 shown in FIG. 18 has a pair of electrodes 102 provided on the outer wall surfaces 101a of the light-emitting tube 101 to face each other, and a reflective coating 103 formed on the wall surface of the light-emitting tube 101 to change the travelling direction of the ultraviolet light L1 from the +X direction to the -X direction, where the -X direction in FIG. 18 being defined as a direction of extracting the light. As shown in FIG. 18, the conventional excimer lamp 100 is provided with the light-collecting area 105, which is an opening in a part of this reflective coating 103 to extract the ultraviolet light L1 from a place other than the light-emitting surface 104.

In the following explanation, the direction in which the light-emitting tube 101 of the excimer lamp 100 extends (tube axial direction) is defined as the Z direction, the direction in which the electrodes 102 face each other is defined as the X direction, and the direction perpendicular to the X direction and the Z direction is defined as the Y direction, as shown in FIG. 18. In the case of describing a direction to distinguish a positive direction from a negative direction, a positive or negative sign is added to the direction, such as "+Z direction" or "-Z direction". In the case of describing a direction without distinguishing a positive direction from a negative direction, the direction is simply expressed as "Z direction".

In this configuration, the ultraviolet light L1 emitted from the light-collecting area 105 is only the ultraviolet light L1 emitted from the light-emitting tube 101 and travels toward the light-collecting area 105, and does not include the light reflected by the reflective coating 103, for example, the ultraviolet light L1 emitted from the light-emitting surface 104 toward the irradiated object. Hence, the excimer lamp 100 of the conventional configuration is not capable of detecting the light output toward the irradiated object, which is influenced by the deterioration state of the reflective coating 103, even though the light emitted from the light-collecting area 105 is measured by the light sensor.

Since the light-emitting tube 101 undergoes the transmittance variation over time caused by the emitted ultraviolet light L1, the amount of the variation depends on the material that constitutes the light-emitting tube 101. Furthermore, the variation that arises in the light-emitting tube 101 and reflective coating 103 over time, depends on the operating environment or the like, and is not likely to exhibit a consistent variation. In other words, it has also been difficult to predict the variation characteristics of the light-emitting tube 101 and the state of deterioration by using correlation data between the light output and the state of deterioration.

In view of the above issue, the object of the present invention is to provide an excimer lamp that is capable of detecting the light output state more accurately.

### Solution to the Problem

An excimer lamp according to the present invention includes a long light-emitting tube transparent to ultraviolet light, a pair of electrodes disposed separately along the radial direction of the light-emitting tube, and a reflective coating formed on the inner wall surface of the light-emitting tube. The reflective coating includes a first reflective area facing the light-emitting surface that emits light toward the light irradiation target area, and a second reflective area facing the light-collecting area located at a position different from the light-emitting surface.

The light emitted from the light-emitting surface includes the light emitted from the inside of the light-emitting tube and travels toward the light-emitting surface, and the light reflected by the first reflective area of the reflective coating and travels toward the light-emitting surface. The light emitted from the light-collecting area includes the light emitted from the inside of the light-emitting tube and travels toward the light-collecting area, and the light reflected by the second reflective area of the reflective coating and travel toward the light-collecting area.

Since the light emitted from the light-collecting area includes the light reflected by the reflective coating, which is similar to the light emitted from the light-emitting surface, it is possible to detect light output variation over time, including deterioration of the reflective coating of the excimer lamp.

In the excimer lamp described above, the light-collecting area may be formed at a position different from the effective light-emitting area on the light-emitting surface side of the light-emitting tube with respect to the tube axial direction of the light-emitting tube.

In the excimer lamp that is composed of a long light-emitting tube, the intensity of the emitted light at the end side of the lamp is relatively lower than that at the central side thereof along the tube axis because of the less amount of irradiation at the ends.

To prevent the uneven irradiation toward the irradiated object, the excimer lamp is usually composed of a light-emitting tube that is longer than the width of the irradiated object (the width refers to a length in the same direction as the tube axial direction) and the irradiation process takes place using only the area of the central side where the emitted light has a predetermined light intensity or higher.

In this specification, "effective light-emitting area" refers to an area, with respect to the tube axial direction of the light-emittingtube, where the emitted light has a predetermined intensity and can be used to irradiate the irradiated object. Specifically, the area refers to an area where the emitted light has a light intensity of 60% or more of its peak value in the light intensity distribution along the tube axis of the light-emitting tube.

In the configuration described above, the effective light-emitting area does not have a light-collecting area or a second reflective area of the reflective coating, and is capable of emitting the light with a uniform intensity distribution toward the irradiated object.

In the excimer lamp described above, the light-collecting area may be formed on the opposite surface of the light-emitting surface.

As described above, the excimer lamp emits ultraviolet light and has an area near the light-emitting surface where ultraviolet light with high intensity is exposed. Ultraviolet light has higher energy than visible light, thus the characteristics including light-receiving sensitivity of light sensors, which measure the light emitted from the light-collecting area, may rapidly deteriorate when the sensors are irradiated with high intensity light.

The above configuration allows the light sensor to be less exposed to the intense light (especially ultraviolet light) emitted from the light-emitting surface, thereby preventing the rapid degradation of the light-receiving sensitivity or the like.

In the excimer lamp described above, the reflective coating may consist of a first reflective coating that constitutes the first reflective area, and a second reflective coating that constitutes the second reflective area, the second reflective coating being formed at a position separating from the first reflective coating.

In the excimer lamp described above, the second reflective coating may be formed closer to the end side of the light-emitting tube than the first reflective coating with respect to the tube axial direction of the light-emitting tube.

In the case where the first reflective coating and the second reflective coating overlap partially in the tube axial direction, light repeatedly reflects in the overlapping area. This repeated reflection may cause a large variation in the light intensity near the overlapping area of the light-emitting surface or the light-collecting area, or the local and rapid deterioration of the reflective coating.

The configuration described above, where the first reflective coating and the second reflective coating do not overlap in the tube axial direction, prevents light from reflecting repeatedly between the first reflective coating and the second reflective coating, hence suppressing the large local variation in light intensity distribution of the light emitted from the light-emitting surface and the light-collecting area.

The light irradiation device according to the present invention includes the excimer lamp, a light sensor having a light-receiving part, the light sensor for detecting the light incident on the light-receiving part, and the light sensor is disposed such that the light-receivable area of the light-receiving part is included in the light-collecting area.

The configuration above allows the light emitted from the light-collecting area of the excimer lamp to be measured by the light sensor, thereby detecting the amount of the variation of the light emitted from the light-emitting surface of the excimer lamp and the amount of the degradation of the reflective coating.

The present invention enables an excimer lamp that is capable of detecting the light output state more accurately.

### BRIEF DESCRIPTION OF DRAWINGS

FIG. 1 is a schematic view of a light irradiation device according to an embodiment of the present invention viewed from the Y direction.
FIG. 2 is a schematic cross-sectional view of an excimer lamp according to an embodiment of the present invention viewed from the Y direction.
FIG. 3 is an enlarged perspective view near a light-collecting area of the excimer lamp shown in FIG. 2.
FIG. 4 is a schematic view of the excimer lamp shown in FIG. 2 viewed from the X direction.
FIG. 5 is a schematic cross-sectional view of the excimer lamp shown in FIG. 2 viewed from the Z direction.
FIG. 6 is a schematic view of the excimer lamp shown in FIG. 2 viewed from the +X side, and a graph illustrating the intensity distribution of the ultraviolet light emitted from the light-emitting surface.
FIG. 7 is a schematic cross-sectional view of the light irradiation device shown in FIG. 1 viewed from the Z direction.
FIG. 8 is a schematic view of the light irradiation device shown in FIG. 1 viewed from the +X side.
FIG. 9A is a schematic cross-sectional view near the light-collecting area of the light-emitting tube viewed from the Y direction.
FIG. 9B is a cross-sectional view of the light-emitting tube, illustrating a state in which a masking tape is attached to the inner wall of the light-emitting tube shown in FIG. 9A.
Fig. 9C is a cross-sectional view of the light-emitting tube, illustrating a state in which suspension that forms a reflective coating is applied to the inner wall surface of the light-emitting tube shown in Fig. 9B.
FIG. 9D is a cross-sectional view of the light-emitting tube, illustrating a state in which the masking tape is removed from the light-emitting tube shown in FIG. 9C.
FIG. 10 is a schematic cross-sectional view of an excimer lamp according to another embodiment viewed from the Y direction.
FIG. 11 is an enlarged perspective view near a light-collecting area of the excimer lamp shown in FIG. 10.
FIG. 12A is a schematic cross-sectional view of an excimer lamp according to another embodiment viewed from the Z direction.
FIG. 12B is a schematic cross-sectional view of the excimer lamp shown in FIG. 12A viewed from the Y direction.
FIG. 13A is a schematic cross-sectional view of an excimer lamp according to another embodiment viewed from the Z direction.
FIG. 13B is a schematic cross-sectional view of the excimer lamp shown in FIG. 13A viewed from the Y direction.
FIG. 14 is a schematic cross-sectional view of an excimer lamp according to another embodiment viewed from the Y direction.
FIG. 15 is a schematic cross-sectional view of an excimer lamp according to another embodiment viewed from the Y direction.
FIG. 16 is a schematic cross-sectional view of an excimer lamp according to another embodiment viewed from the Y direction.
FIG. 17 is an enlarged perspective view near a light-collecting area of an excimer lamp according to another embodiment.
FIG. 18 is an enlarged perspective view near a light-collecting area of an excimer lamp of conventional configuration.

### DESCRIPTION OF EMBODIMENTS

Embodiments of an excimer lamp and a light irradiation device according to the present invention are described with reference to the drawings. Since each drawing is illustrated schematically, it is noted that the dimensional ratios and the numbers of parts in each drawing do not necessarily match the actual dimensional ratios and the numbers of parts.

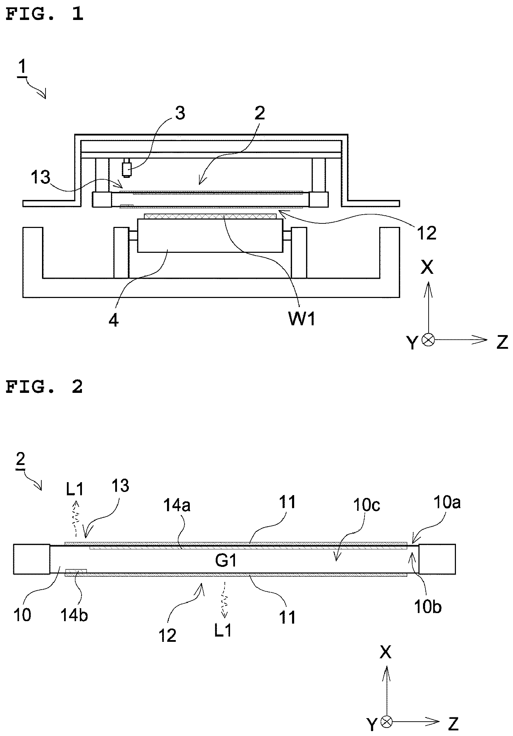

FIG. 1 is a schematic view of a light irradiation device according to an embodiment of the present invention viewed from the Y direction. As shown in FIG. 1, the light irradiation device 1 includes an excimer lamp 2, a light sensor 3, and a transport mechanism 4 that places an irradiated object W1.

In the following description, the direction in which the excimer lamp 2 extends (tube axial direction) is defined as the Z direction and the plane parallel to the light-emitting surface 12 of the excimer lamp 2 is defined as the YZ plane specified by the Y direction and Z direction as shown in FIG. 1. In the case of describing a direction to distinguish a positive direction from a negative direction, a positive or negative sign is added to the direction, such as "+Zdirection" or "-Zdirection". In the case of describing a direction without distinguishing a positive direction from a negative direction, the direction is simply expressed as "Z direction".

The configuration of an excimer lamp 2 is described below. The excimer lamp 2 is disposed to allow a light-emitting surface 12 to face a transport mechanism 4 so as to irradiate an irradiated object W1 with ultraviolet light.

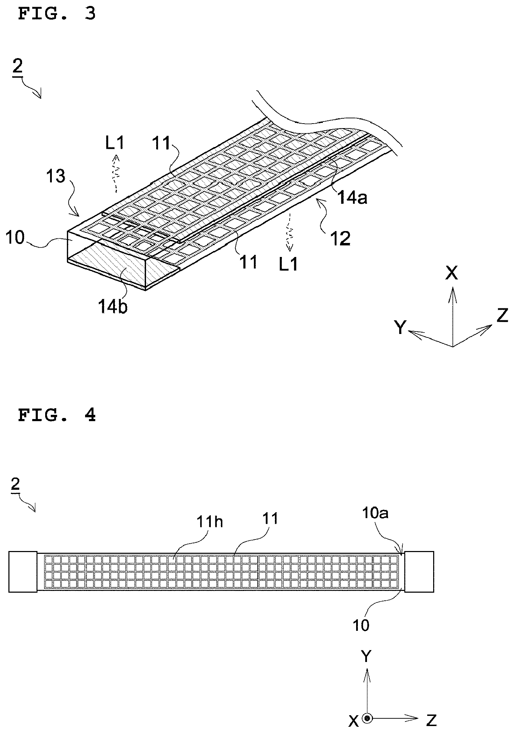

FIG. 2 is a schematic cross-sectional view of an excimer lamp according to an embodiment of the present invention viewed from the Y direction. FIG. 3 is an enlarged perspective view near a light-collecting area 13 of the excimer lamp 2 shown in FIG. 2. As shown in FIG. 2, the excimer lamp 2 is provided with a light-emitting tube 10, a pair of electrodes 11, a light-emitting surface 12, a light-collecting area 13, a first reflective coating 14a and a second reflective coating 14b. In FIG. 3, the -Z side from the second reflective coating 14b of the excimer lamp 2 is not shown so that the shape of the second reflective coating 14b can be readily recognized. In the following description, the direction in which the light-emitting tube 10 of the excimer lamp 2 extends (tube axial direction) is the Z direction, the direction in which the electrodes 11 face each other is the X direction, and the direction perpendicular to the X direction and Z direction is the Y direction, as shown in FIGS. 2 and 3. This definition corresponds to the definition of the direction according to FIG. 1 with the excimer lamp 2 being mounted into the light irradiation device 1.

The light-emitting tube 10 is made of a material (e.g., quartz glass) that is transparent to light (especially ultraviolet light). As shown in FIG. 2, the light-emitting tube 10 has a light-emitting space 10c, which is a long space and is filled with light-emitting gas G1 inside, and radiates ultraviolet light L1 generated inside the light-emitting space 10c toward the outside.

FIG. 4 is a schematic view of the excimer lamp 2 shown in FIG. 2 viewed from the X direction. The light-emitting tube 10 is provided with an electrode 11 formed in a mesh shape on the outer wall surface 10a of the light-emitting tube 10, and a light extraction area 11h, which are composed of a plurality of openings, for extracting the light emitted from the light-emitting space 10c of the light-emitting tube 10. Applying the voltage necessary for luminescence to the electrode 11 generates an electrical discharge in the light-emitting space 10c, thus emitting ultraviolet light L1 from the light extraction area 11h.

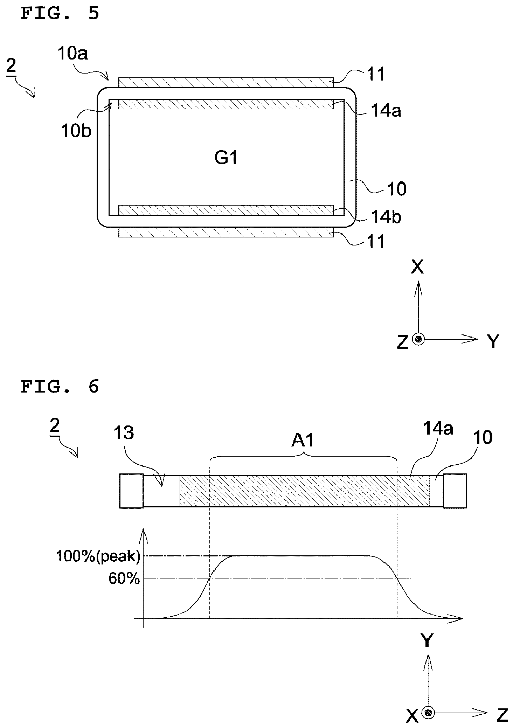

FIG. 5 is a schematic cross-sectional view of the excimer lamp shown in FIG. 2 viewed from the Z direction. As shown in FIG. 5, the light-emitting tube 10 of the present embodiment has a rectangular cross-section when cut in the XY plane, and is provided with a pair of electrodes 11 on the flat outer wall surfaces 10a facing each other. The cross-sectional shape of the light-emitting tube 10 may be circular, elliptical, or other polygonal shapes such as hexagonal or octagonal.

The light-emitting surface 12 (see FIGS. 2 and 3) is a part of the wall area of the light-emitting tube 10 that emits ultraviolet light L1 emitted from the light-emitting space 10c of the light-emitting tube 10 toward the irradiated object W1. Among the ultraviolet light L1 emitted from the light-emitting space 10c, the ultraviolet light L1 travelling toward the light-emitting surface 12 passes through the light extraction area 11 h of the electrode 11 and emits toward the outside of the light-emitting tube 10.

Among the ultraviolet light L1 emitted from the light-emitting space 10c, the ultraviolet light L1 travelling toward the opposite side of the light-emitting surface 12, i.e., the +X direction, is reflected by the first reflective coating 14a, travels toward the light-emitting surface 12 side, i.e., the -X direction, passes through the light extraction area 11 h of the electrode 11, and emits toward the outside of the light-emitting tube 10.

A light-collecting area 13 is an output window of the ultraviolet light L1 formed on the wall surface of the light-emitting tube 10 to measure the light intensity of the ultraviolet light L1 emitted from the light-emitting space 10c of the light-emitting tube 10 with the light sensor 3. Among the ultraviolet light L1 emitted from the light-emitting space 10c, the ultraviolet light L1 travelling toward the light-collecting area 13 passes through the light extraction area 11h of the electrode 11, and emits toward the outside of the light-emitting tube 10.

Among the ultraviolet light L1 emitted from the light-emitting space 10c, the ultraviolet light L1 travelling toward the -X direction, which is opposite side of the light-collecting area 13, is reflected by the second reflective coating 14b, travels toward the +X direction of the light-collecting area 13 side, passes through the light extraction area 11 h of the electrode 11, and emits toward the outside of the light-emitting tube 10.

The second reflective coating 14b is formed closer to the end of the light-emitting tube 10 than the first reflective coating 14a, as shown in FIG. 2. As shown in FIG. 3, the first reflective coating 14a and the second reflective coating 14b are formed to face each other when viewed from the Z direction.

Hereinafter, the positional relationship between the effective light-emitting area and the light-collecting area described above is explained. The effective light-emitting area refers to an area where the light with a predetermined light intensity is output with respect to the Z direction and can be used to irradiate the irradiated object W1; specifically, the area refers to an area where the emitted light has a light intensity of 60% or more of its peak value in the light intensity distribution along the Z direction.

FIG. 6 is a schematic view of the excimer lamp 2 viewed from the +X side and a graph illustrating the intensity distribution of the ultraviolet light L1 emitted from the light-emitting surface 12. As shown in FIG. 6, the effective light-emitting area A1 is a part of the central side of the light-emitting surface 12 facing the first reflective coating 14a. In Fig. 6, the electrodes 11 are not shown and the light-emitting surface 12 is hidden by the first reflective coating 14a to readily recognize the internal structure of the light-emitting tube 10.

The above configuration allows the light-collecting area 13 to be formed at a position different from the effective light-emitting area A1 of the light-emitting surface 12. In the case of an excimer lamp 2 having a plurality of light-emitting surfaces 12, the light-collecting area 13 is formed at a position different from the corresponding effective light-emitting areas A1.

Since the ultraviolet light L1 emitted from the light-collecting area 13 is expected to correlate with the ultraviolet light L1 reflected by the same reflective coating for reflecting light to emit from the light-emitting surface 12, it is preferable that the first reflective coating 14a and the second reflective coating 14b be formed with the same material.

The materials that constitute the first reflective coating 14a and the second reflective coating 14b can be obtained, for example, by coating and firing suspension or the like that contains particulate silica (SiO₂), alumina (Al₂O₃), or the like.

The configuration described above allows the ultraviolet light L1 emitted from the light-collecting area 13 to include the ultraviolet light L1 that is emitted from the light-emitting space 10c of the light-emitting tube 10 and travels toward the light-collecting area 13, and the ultraviolet light L1 that is reflected by the second reflective coating 14b and travels toward the light-collecting area 13. Thereby this configuration is capable of detecting the light output variation over time, including the deterioration of the reflective coating of the excimer lamp 2.

According to the above embodiment, since the second reflective coating 14b is formed closer to the end side than the first reflective coating 14a with respect to the Z-direction, light does not repeatedly reflect between the first reflective coating 14a and the second reflective coating 14b. This configuration suppresses a large local variation in the intensity distribution of the light emitted from the light-emitting surface 12 and the light-collecting area 13.

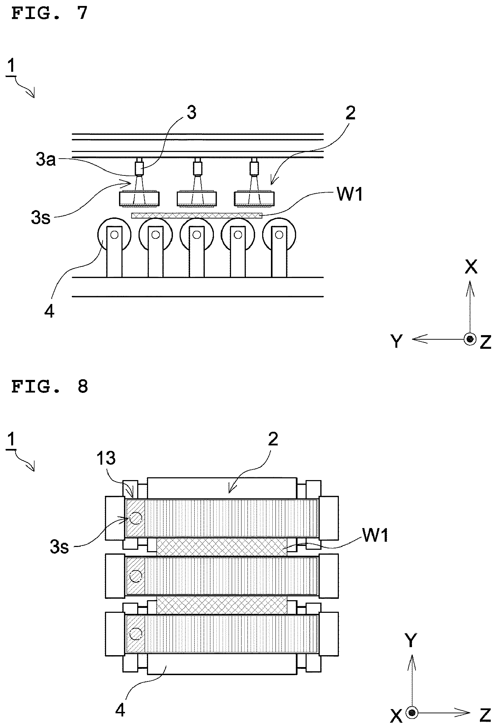

Next, the configuration of the light irradiation device 1 other than the excimer lamp 2 is described. FIG. 7 is a schematic cross-sectional view of the light irradiation device shown in FIG. 1 viewed from the Z direction. FIG. 8 is a schematic view of the light irradiation device viewed from the + X side. A light sensor 3 includes a light-receiving part 3a and has a specific light-receivable area 3s as shown in FIGS. 7 and 8.

As shown in FIGS. 7 and 8, the light sensors 3 are arranged to allow the light-receivable area 3s to be included in the light-collecting area 13 of the excimer lamp 2 so that the light-receiving part 3a can sufficiently receive the ultraviolet light emitted from the light-collecting area 13 of the excimer lamp 2. The light sensor 3 may be provided with a light guide member that guides the light collected by the light guide member to the light-receiving part 3a, thus the area where the light is collected by the light guide member is included in the light-collecting area 13 of the excimer lamp 2. In other words, the light sensor 3 may not be disposed to face the light-collecting area 13.

The light sensor 3 can, for example, adopt a silicon photodiode. The light sensor 3 may be configured to directly measure the light emitted from the light-collecting area 13 using a silicon photodiode. The light sensor 3 may be configured to convert the wavelength of the light to the wavelength range that is measurable to the sensor, using a fluorescent material or the like, if the wavelength range that can be measured by the silicon photodiode is different from the wavelength of the light emitted from the light-collecting area 13.

The transport mechanism 4 is configured to transport the irradiated object W1 that has been placed thereon, to allow the irradiated object W1 to pass through the light irradiation target area of the excimer lamp 2, and to irradiate the irradiated object W1 with ultraviolet light emitted from the light-emitting surface 12. In the present embodiment, the transport mechanism 4 is configured to transport the irradiated object W1 in the Y direction.

The transport mechanism 4 according to the present embodiment, is composed of a plurality of rollers that are arranged separately and spaced apart; however, the transport mechanism 4 can be any configuration, such as a belt-like conveyor, that can transport the irradiated object W1 toward a predetermined direction while maintaining a separation distance between the excimer lamp 2 and the irradiated object W1.

The light irradiation device 1 according to the present embodiment determines the deterioration state of the excimer lamp 2 by measuring the amount of light with the light sensor 3, which receives the ultraviolet light emitted from the light-collecting area 13 of the excimer lamp 2 through the light-receiving part 3a.

Hereinafter, the method of forming the first reflective coating 14a and the second reflective coating 14b according to the present embodiment is described below.

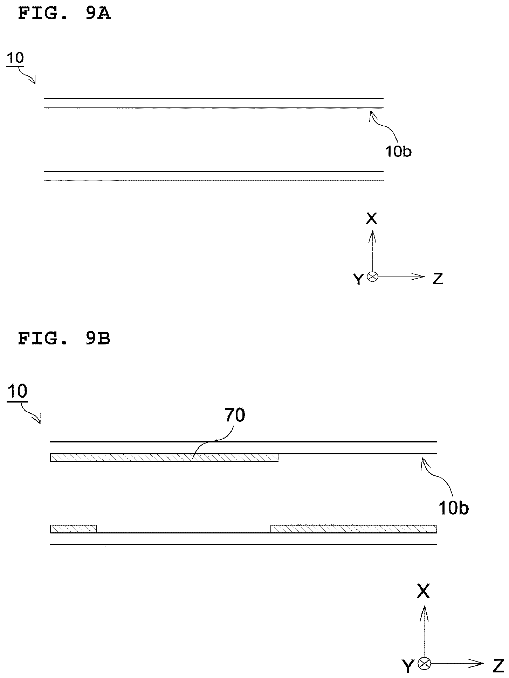

FIG. 9A is a schematic cross-sectional view near the light-collecting area 13 of the light-emitting tube 10 viewed from the Y direction. The first step is to prepare the light-emitting tube 10, as shown in FIG. 9A.

FIG. 9B is a cross-sectional view of the light-emitting tube 10, illustrating a state in which a masking tape 70 is attached to the inner wall 10b of the light-emitting tube 10 shown in FIG. 9A. The second step is to apply the masking tape 70 to a part of the inner wall surface 10b of the light-emitting tube 10 prepared in the first step, the part being an area where a reflective coating is not to be formed, as shown in FIG. 9B.

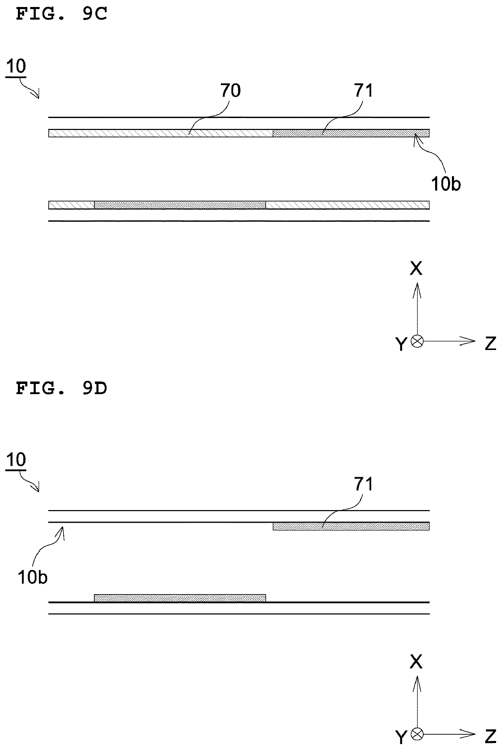

FIG. 9C is a cross-sectional view of the light-emitting tube 10, illustrating the state in which suspension 71 that forms the reflective coating is applied to the inner wall surface 10b of the light-emitting tube 10 shown in FIG. 9B. As described above, the suspension 71 is prepared from particulate silica (SiO₂), alumina (Al₂O₃), or the like. The third step is to apply the suspension 71 to the inner wall surface 10b of the light-emitting tube 10, where the masking tape 70 has been attached in the second step, for forming a reflective coating, as shown in FIG. 9C. The method of applying the suspension 71 can include a method of inserting a nozzle inside the light-emitting tube 10 and sweeping it, or a method of pouring the suspension 71 into the light-emitting tube 10.

FIG. 9D is a cross-sectional view of the light-emitting tube 10, illustrating a state in which the masking tape is removed from the light-emitting tube 10 shown in FIG. 9C. The fourth step is to remove the masking tape 70 after the suspension 71 applied in the third step has been dried, as shown in FIG. 9D.

The fifth step is to fire the dried suspension 71 on the inner wall surface 10b of the light-emitting tube 10 to form the reflective coating.

Through the above steps, the first reflective coating 14a and the second reflective coating 14b are formed, as shown in FIG. 3. As for the wall surface facing across the Y direction, no reflective coating is formed according to the present embodiment, thus the explanation is omitted; however, in the case of forming a reflective coating on the wall surface concerned, the masking tape 70 can be attached to the inner wall surface 10b of the light-emitting tube 10 in an appropriate shape in the second step, and suspension 71 can be applied thereto.

The second reflective coating 14b may not be formed entirely at a position facing the light-collecting area 13. In the case that the second reflective coating 14b is provided in the light irradiation device 1, it is preferable that the area of the second reflective coating 14b account for 50% or more of the area of the light-receivable area 3s of the light sensor 3.

### Another embodiment

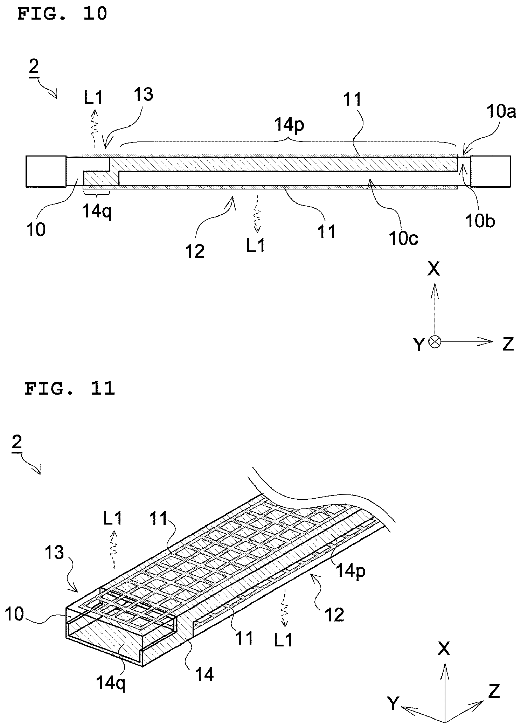

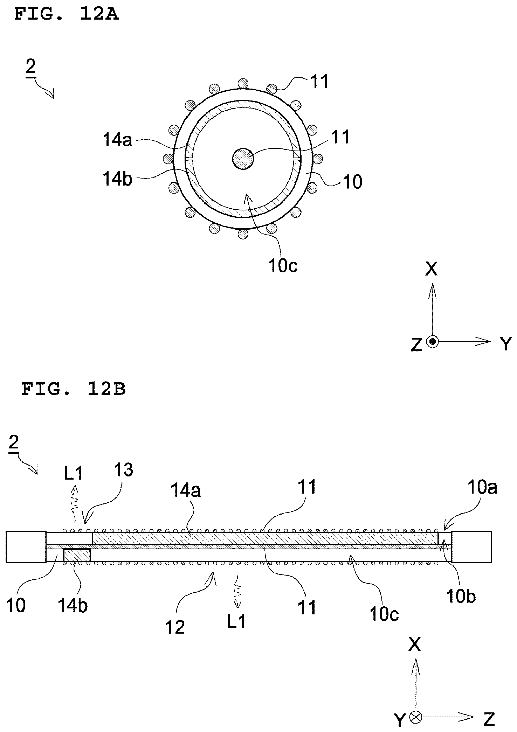

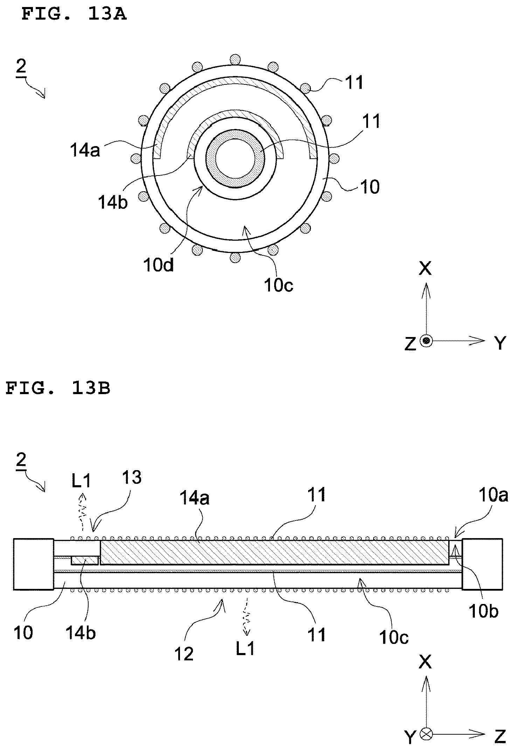

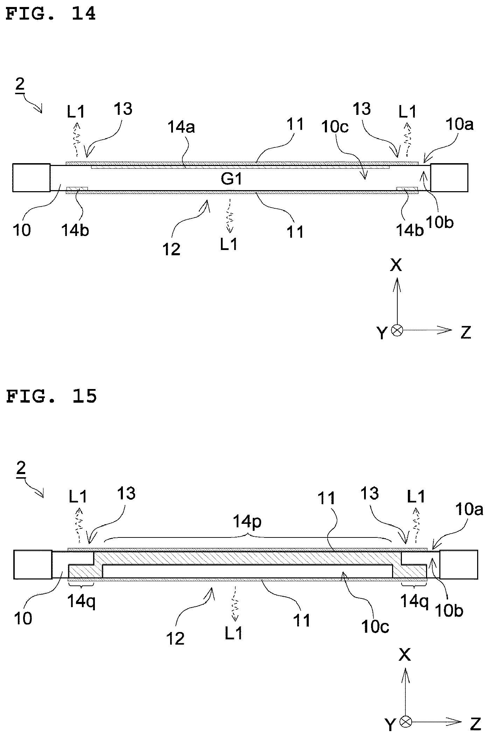

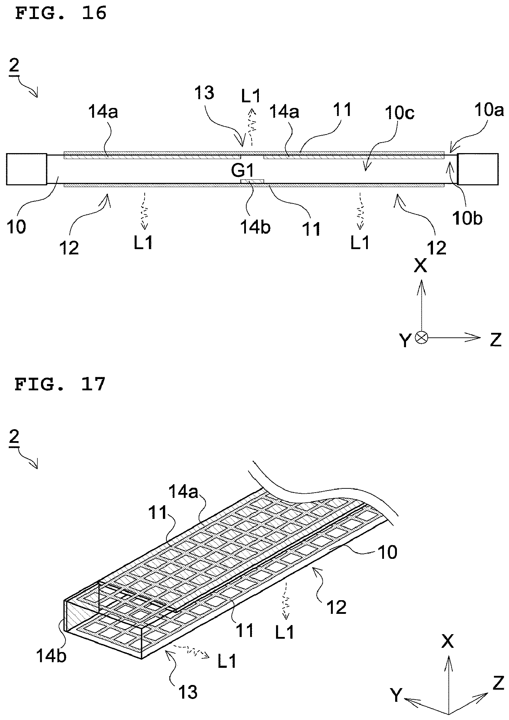

Hereinafter, another embodiments is described.
<1> FIG. 10 is a schematic cross-sectional view of an excimer lamp 2 according to another embodiment viewed from the Y direction. FIG. 11 is an enlarged perspective view near a light-collecting area 13 of the excimer lamp 2 shown in FIG. 10. As shown in FIGS. 10 and 11, the excimer lamp 2 may be provided with an integrated reflective coating 14 that combines a first reflective area 14p that reflects ultraviolet light L1 toward the light-emitting surface 12 side, with a second reflective area 14q that reflects ultraviolet light L1 toward the light-collecting area 13 side. In FIG. 11, the -Z side from the second reflective area 14q is not shown to readily recognize the shape of the reflective coating 14.
   As shown in FIGS. 10 and 11, the reflective coating 14 has the first reflective area 14p formed at a position facing the light-emitting surface 12, and the second reflective area 14q formed at a position facing the light-collecting area 13. Both of the reflective areas communicate with a member on the side of the light-emitting tube 10, the member being made of the same material as the reflective coating 14. This configuration corresponds to that of the above-mentioned embodiment, in which the first reflective coating 14a and the second reflective coating 14b are both formed in the circumferential direction around the tube axis of the light-emitting tube 10, both of the reflective coatings facing each other in the X direction for more than half a circumference and partially overlapping in the Z direction.
<2> FIGS. 12A and 13A are schematic cross-sectional views of the excimer lamp 2 according to another embodiment viewed from the Z direction. FIG. 12B is a schematic cross-sectional view of the excimer lamp shown in FIG. 12A viewed from the Y direction. FIG. 13B is a schematic cross-sectional view of the excimer lamp shown in FIG. 13A viewed from the Y direction. In the excimer lamp 2 described above with reference to FIG. 5, the light-emitting tube 10 has a rectangular shape when viewed in the Z direction, the shape being a configuration that is called a flat tube shape. However, the excimer lamp 2 is not limited to this configuration, and can be configured as a shape called a single tube as shown in FIG. 12A, or a shape called a double tube as shown in FIG. 13A.
   In the double tube shape excimer lamp 2 as shown in FIG. 13A, the second reflective coating 14b is formed on the tube wall surface 10d that is located inside the light-emitting tube 10. In FIG. 13A, the second reflective coating 14b is formed on the inner tube wall surface 10d of the light-emitting tube 10 for only half the circumference along the circumferential direction; however, the second reflective coating 14b may be formed over the entire circumference.
   In all the configurations of the shapes, a pair of electrodes 11 are formed to be separated in the radial direction around the tube axis of the light-emitting tube 10. In all the configurations shown in FIGS. 12A to 13B, the electrode 11 formed on the outer wall surface side of the light-emitting tube 10 is a mesh electrode made of metal wire; however, the electrode 11 may be a metal coating formed by vapor deposition, or a metal plate. The electrode is not limited to the configuration shown in the figure described above, such as the electrode 11 disposed in the light-emitting space 10c of the light-emitting tube 10 shown in FIG. 12A, or the electrode 11 formed inside the light-emitting tube 10 shown in FIG. 13A.
<3> A plurality of the first reflective coatings 14a and the second reflective coatings 14b may be formed in an excimer lamp 2. The reflective coating 14 may have a plurality of the first reflective areas 14p and the second reflective areas 14q. FIGS. 14 to 16 is a schematic cross-sectional view of an excimer lamp 2 according to another embodiment viewed from the Y direction. For example, the excimer lamp may be provided with two light-collecting areas 13, two second reflective coatings 14b and two second reflective areas 14q, as shown in FIGS. 14 and 15.
   Furthermore, as shown in Fig. 16, the second reflective coating 14b may be formed between a plurality of first reflective coatings 14a in the Z direction, and the light-collecting area 13 may be formed on the central side of the light-emitting tube 10 in the excimer lamp 2. Although not shown in the figure, this similar manner may apply to the first reflective area 14p and second reflective area 14q; the second reflective area 14q may be formed between the plurality of first reflective areas 14p, and the light-collecting area 13 may be formed on the central side of the light-emitting tube 10.
<4> FIG. 17 is an enlarged perspective view near a light-collecting area 13 of the excimer lamp 2 according to another embodiment. In the configuration described above, the light-emitting surface 12 and the light-collecting area 13 are both configured to face the X direction; however, as shown in FIG. 17, the light-emitting surface 12 can be formed to face the X direction and the light-collecting area 13 can be formed to face the Y direction. In FIG. 17, the -Z side from the second reflective coating 14b is not shown to readily recognize the shape of the second reflective coating 14b.
<5> The above-mentioned configurations of the light irradiation device 1 and excimer lamp 2 are merely an example of the present invention, and the present invention is not limited to each configuration shown in the figures.

### REFERENCE SIGNS LIST

- 1: light irradiation device
- 2: excimer lamp
- 3: light sensor
- 3a: light-receiving part
- 3s: light-receivable area
- 4: transport mechanism
- 10: light-emitting tube
- 10a: outer wall surface
- 10b: inner wall surface
- 10c: light-emitting space
- 10d: tube wall surface
- 11: electrode
- 11 h: light extraction area
- 12: light-emitting surface
- 13: light-collecting area
- 14: reflective coating
- 14a: first reflective coating
- 14b: second reflective coating
- 14p: first reflective area
- 14q: second reflective area
- 70: masking tape
- 71: suspension
- 100: excimer lamp
- 101: light-emitting tube
- 101a: outer wall surface
- 102: electrode
- 103: reflective coating
- 104: light-emitting surface
- 105: light-collecting area
- A1: effective light-emitting area
- G1: discharge gas
- L1: ultraviolet light
- W1: irradiated object

## Claims

1. An excimer lamp (2) comprising:
a long light-emitting tube (10) transparent to ultraviolet light, the light-emitting tube (10) having a light-emitting surface (12) that emits the light toward a light irradiation target area;
a pair of electrodes (11) disposed separately along the radial direction of the light-emitting tube (10);
a reflective coating (14) formed on the inner wall surface (10b) of the light-emitting tube (10); and
a light-collecting area (13) disposed on the wall surface of the light-emitting tube (10);
wherein the reflective coating (14) includes a first reflective area (14p) facing the light-emitting surface (12), and a second reflective area (14q) facing the light-collecting area (13) disposed at a position different from the light-emitting surface (12).

2. The excimer lamp (2) according to claim 1, wherein the light-collecting area (13) is formed at a position different from the effective light-emitting area (A1) of the light-emitting surface (12) side of the light-emitting tube (10) with respect to the tube axial direction of the light-emitting tube (10).

3. The excimer lamp (2) according to claims 1 or 2, wherein the light-collecting area (13) is formed on the opposite surface of the light-emitting surface (12).

4. The excimer lamp (2) according to any one of claims 1 to 3, wherein the reflective coating (14) includes a first reflective coating (14a) that constitutes the first reflective area (14p), and a second reflective coating (14b) that constitutes the second reflective area (14q), the second reflective coating (14b) being formed at a position separating from the first reflective coating (14a).

5. The excimer lamp (2) according to claim 4, wherein the second reflective coating (14b) is formed closer to the end side of the light-emitting tube (10) than the first reflective coating (14a) with respect to the tube axial direction of the light-emitting tube (10).

6. A light irradiation device (1) comprising:
the excimer lamp (2) according to any one of claims 1 to 5; and
a light sensor (3) including a light-receiving part (3a) and having a light-receivable area (3s), the light sensor (3) for detecting the light incident on the light-receiving part (3a),
wherein the light sensor (3) is disposed such that the light-receivable area (3s) of the light-receiving part (3a) is included in the light-collecting area (13).
